Europäisches Patentamt

European Patent Office

Office européen des brevets

(11) Veröffentlichungsnummer: **0 213 308**
**B1**

# (12) EUROPÄISCHE PATENTSCHRIFT

(45) Veröffentlichungstag der Patentschrift:
07.06.89

(21) Anmeldenummer: 86108794.8

(22) Anmeldetag: 27.06.86

(51) Int. Cl.⁴: **B66B 13/26,** H03K 17/955,
H03K 17/98

(54) Einrichtung an automatischen Türen zur Erkennung von Hindernissen.

(30) Priorität: 22.08.85 CH 3612/85

(43) Veröffentlichungstag der Anmeldung:
11.03.87 Patentblatt 87/11

(45) Bekanntmachung des Hinweises auf die Patenterteilung:
07.06.89 Patentblatt 89/23

(84) Benannte Vertragsstaaten:
AT BE CH DE FR GB IT LI NL SE

(56) Entgegenhaltungen:
WO-A-82/02536
DE-A- 2 453 439
FR-A- 2 371 676
US-A- 4 261 440
US-A- 4 349 858

(73) Patentinhaber: INVENTIO AG, Seestrasse 55,
CH-6052 Hergiswil NW(CH)

(72) Erfinder: Baumgartner, Max, Dr., Schädrütihalde 10,
CH-6006 Luzern(CH)

**Beschreibung**

Die vorliegende Erfindung betrifft eine Einrichtung an automatischen Türen - insbesondere an automatisch gesteuerten Aufzugstüren - zur Erkennung von Hindernissen, enthaltend kapazitive Sensoren, die je ein Sensorsignal abgeben und über die Türschliesskante verteilte Antennen aufweisen; Differentialverstärker zum Empfang und Vergleich je zweier Sensorsignal und zur Erzeugung eines Fehlersignales; auf die kapazitiven Sensoren einwirkende Kompensatoren zur Kompensation je eines Fehlersignales sowie eine Auswerteschaltung zur Abgabe eines Türsteuerungssignales.

Einrichtungen der angegebenen Art dienen dem Erkennen von Personen oder Gegenständen innerhalb eines festgelegten Raumgebietes und sind deshalb allgemein als Sicherheitseinrichtungen anwendbar, wie z.B. zur Einbruchsicherung von Räumen, als Personenschutz bei gefährlichen Maschinen, zur Sicherung von Arbeitsplattformen sowie als Antikollisionsschutz an Fahrzeugen.

Der bisherige Stand der Technik bei der Schliessicherung von automatischen Aufzugstüren ist gekennzeichnet durch die Verwendung von Sensoren unterschiedlichster Bauart, wie z.B. mechanische Fühlerleisten, Lichtschranken, Ultraschallgeräte sowie kapazitive und induktive Messeinrichtungen.

So ist z.B. aus der internationalen Patentanmeldung WO 82/02536 eine Schliessicherung für insbesondere Aufzugstüren bekannt, bei der kapazitive Näherungssensoren mit über den Türkanten verteilten Antennen verwendet werden. Die von den Näherungssensoren abgegebenen Sensorsignale hängen von den Erdkapazitäten der zugehörigen Antennen ab und sind paarweise auf Differentialverstärker geführt, die daraus in bekannter Weise Fehlersignale erzeugen, welche ihrerseits über eine Auswerteschaltung türsteuernd wirksam sind. Hindernisse im Türbereiche, wie z.B. eine Person oder ein Gegenstand, verändern die Erdkapazitäten der Sensorantennen in unterschiedlicher Weise, so dass durch mindestens ein sich daraus ergebendes Fehlersignal das Türschliessen verhindert, gestoppt oder reversiert werden kann. Damit die Differentialverstärker bei der Hinderniserkennung innerhalb ihres regulären Arbeitsbereiches betrieben werden können, müssen die Sensoren in hindernisfreiem Zustand in etwa das gleiche Sensorsignal abgeben - und dies trotz ungleichen z.B. einbaubedingten Erdkapazitäten. Die Sensoren werden deshalb in hindernisfreiem Zustand paarweise abgeglichen, wozu Kompensatoren mit inkrementalen Abgleichspeichern vorgesehen sind und jeder Sensor einen speziellen Kompensationseingang aufweist. Je ein Kompensator ist mit einem Differentialverstärker und einem der beiden zugehörigen Sensoren zu einem Regelkreis verknüpft, der das eine Sensorsignal an das andere angleicht, bis das zugehörige Fehlersignal "0" ist. Diese Kompensation erfolgt bei hindernisfreier, z.B. 1 cm geöffneter Türe und wird zu Beginn jeder Öffnungsbewegung selbsttätig durch einen Mikroschalter ausgelöst. Aus dieser und ähnlichen, elektronisch arbeitenden Türsicherungen ist das Problem bekannt, zu unterscheiden, ob ein Fehlersignal von einem Hindernis stammt und deshalb türsteuernd wirksam sein muss, oder ob es durch eine Störbeeinflussung verursacht wurde und somit für die Zwecke der Türsteuerung zu vernachlässigen ist. Solche Störbeeinflussungen ergeben sich aus der baulichen Gestaltung des Aufzugsschachtes, unruhig laufenden und schlecht fluchtenden Türen, mechanischen Toleranzen sowie Langzeiteinflüssen wie Schmutz, Feuchtigkeit und mechanischen Deformationen. Zur Lösung dieses Problems geht die vorgenannte Patentschrift von der Erkenntnis aus, dass bei normaler Arbeitsweise einer Aufzugsanlage Hindernisse, wie Personen und Gegenstände, zu schnellveränderlichen Fehlersignalen führen, während Störbeeinflussungen langsamveränderliche Fehlersignale erzeugen. Die Unterscheidung zwischen Hindernis und Störbeeinflussung erfolgt deshalb durch Pseudo-Differentiation des entsprechenden Fehlersignales, d.h. durch Vergleich des unverzögerten mit dem zeitlich verzögerten Fehlersignal in einem zusätzlichen Differentialverstärker. Obwohl die dermassen ausgebildete Türsicherung einen durchaus funktionsfähigen Einklemmschutz darstellt, haften ihr doch gewichtige Nachteile an:

Erste wesentliche Nachteile ergeben sich aus dem Umstande, dass die Funktion der Kompensatoren auf eine Wegstrecke von wenigen Zentimetern ab Türöffnung beschränkt ist, so dass die Störbeeinflussungen nur in diesem kleinen Türbereiche kompensiert werden und im verbleibenden, weitaus grösseren Teil des Türweges unkompensiert bleiben. Es handelt sich deshalb dabei eher um einen stockwerkbezogenen, punktuellen Abgleich der Sensoren als um eine Kompensation von Störbeeinflussungen. Nicht nur bedeutet dies eine zeitlich schlechte Ausnützung der vorhandenen Kompensatoren, sondern man ist insbesondere gezwungen, signalmässig zwischen türsteuerungswirksamen Hindernissen und nicht-türsteuerungswirksamen Störbeeinflussungen zu unterscheiden. Da dies in einer Differentierschaltung geschieht, müssen statische Hindernisse, wie z.B. eine im Türbereich stillstehende Person, in einer zusätzlichen "statischen" Schaltung identifiziert werden. Diese Dopplung der Auswerteschaltung ist aufwendig und erfordert zusätzliche Massnahmen um die statische von der dynamischen Schaltung zu entkoppeln. Hiezu kommt als weiterer Nachteil, dass Störbeeinflussungen im Aufzugsschacht, zwischen den Stockwerken, die Funktion der Auswerteschaltung beeinträchtigen können, da die Zeitkonstante des Verzögerungselementes auf die Türbewegungen in einem Stockwerk abgestimmt ist, und nicht auf die Kabinenbewegungen im Aufzugsschacht. Es ist deshalb erforderlich, bei jedem Stockwerkhalt, unmittelbar vor Beginn der Türöffnung, das Zeitelement durch einen Mikroschalter zu initialisieren. Dies kompliziert den Funktionsablauf bei der Hinderniserkennung und mindert deren Zuverlässigkeit und Sicherheit. Ein weiterer Mangel grundsätzlicher Art besteht darin, dass die vorgenannte Hinderniserkennung kein Gedächtnis besitzt, so dass z.B. ein von mechanischer Deformation herrührendes, als Störbeeinflussung erkanntes Fehlersignal bei jeder Türbewegung immer wieder von neuem identifiziert werden muss. Bereits vorgenommene Identifikationen sind also bei nachfolgenden Türbewegungen nicht verwertbar, weshalb auch Langzeiteinflüsse wie Verschmutzung und Feuchtigkeit, welche sich zwischen den Türbewegungen kaum ändern, jedesmal von Grund auf neu identifiziert werden müssen. Ein solcher Identifikationsvorgang ist Fehlersignalen, wie sie sich bei normalem Aufzugsbetrieb ergeben, schlecht angepasst.

Hier will die Erfindung Abhilfe schaffen.

Die Erfindung, wie sie in den Ansprüchen gekennzeichnet ist, stellt sich die Aufgabe, bei der Schliessicherung von Türen mittels Sensoren eine selbsttätige Differentiierung zwischen türsteuerungswirksamen Hindernissen wie Personen oder Gegenstände und nicht-türsteuerungswirksamen Störbeeinflussungen, z.B. durch Schmutz, Temperatur oder mechanische Toleranzen zu schaffen, welche über den vollen Bewegungsbereich der Türen wirksam ist. Im weitern soll die erfindungsgemässe Einrichtung leicht und rasch an unterschiedliche Betriebsbedingungen von Türen anpassbar sein und eine einfache Auswerteschaltung für den Zugriff zur Türsteuerung aufweisen.

Diese Aufgabe wird mit der in den kennzeichnenden Merkmalen des unabhängigen Anspruches beschriebenen Erfindung gelöst. Vorteilhafte Weiterbildungen sind in den abhängigen Ansprüchen angegeben. Darüber hinaus weist eine derart gestaltete Einrichtung an automatischen Türen noch zusätzliche Vorteile auf.

Erste Vorteile ergeben sich aus dem Umstande, dass von Störbeeinflussungen herrührende Fehlersignale durch Kompensation eliminiert werden und deshalb in der Auswerteschaltung nicht mehr zwischen türsteuerungswirksamen Hindernissen und nicht-türsteuerungswirksamen Störbeeinflussungen unterschieden werden muss. Die zeitliche Differentiation zwischen Hindernis- und Störbeeinflussungssignalen ist somit durch den Kompensationsvorgang ersetzt, weshalb die Auswerteschaltung als einfacher Schwellwertdetektor ausgebildet werden kann. Dieser ist gleichermassen zur Identifikation von "statischen" wie "dynamischen" d.h. stillstehenden bzw. sich bewegenden Hindernissen geeignet und somit nur in einfacher Ausführung, also ohne Dopplung, erforderlich. Im weitern entfallen aufgrund der hardwaremässigen Trennung von zeitlicher und amplitudenmässiger Diskrimination die lästigen gegenseitigen Störbeeinflussungen und damit der periodische Reset des Zeitelementes mit dem dazugehörigen Mikroswitch. Da alle Fehlersignale über ein Majoritätsgate auf die Auswerteschaltung gegeben sind, ist auch bei einer Vielzahl von Sensoren nur eine einzige Auswahlschaltung erforderlich. Eine solche Einklemmsicherung ist deshalb leicht nachrüstbar, wenn sich dies bei einer Türsicherung aufgrund wechselnder Betriebsbedingungen als notwendig erweisen sollte. Weitere Vorteile ergeben sich daraus, dass die Kompensation der Fehlersignale bei jeder Türbewegung erfolgt und feinstufig über den ganzen Bewegungsbereich einer Türe aufgeteilt ist. Langsamveränderliche Störbeeinflussungen können so, ungeachtet ihrer Grösse, auf eine minimale Restamplitude auskompensiert werden. Dies ermöglicht eine hohe Empfindlichkeit bei der Hinderniserkennung, reduziert die Anforderungen bezüglich Störabstand und führt zu einer erhöhten Freizügigkeit bei der elektrischen und mechanischen Ausbildung von Türanlage und Schliessicherung. Alle diese Vorteile erfordern keinen wesentlichen Mehraufwand, sondern ergeben sich als Folge einer besseren zeitlichen Ausnützung der ohnehin vorhandenen Kompensatoren.

Die Erfindung ist im folgenden anhand der Beschreibung sowie der Zeichnung in ihrer Anwendung bei der Schliessicherung von automatischen Aufzugstüren näher erläutert, doch ist die hier gezeigte Einrichtung allgemein in der Sicherheitstechnik anwendbar, wie z.B. zur Raumsicherung, als Einklemmschutz an gefährlichen Maschinen, zur Sicherung von Arbeitsplattformen sowie als Kollisionsschutz an Fahrzeugen. In der lediglich dieses Anwendungsbeispiel der Erfindung darstellenden Zeichnung zeigen:

Fig. 1 ein Blockschaltbild der erfindungsgemässen Einrichtung unter Verwendung von drei kapazitiven Näherungssensoren.

Fig. 2 schematisch, den grundlegenden Kompensationsvorgang am Beispiel eines langsamveränderlichen und eines schnellveränderlichen Fehlersignales.

Fig. 3a schematisch, eine Darstellung der Funktionsabläufe beim anfänglichen Initialisieren der Einrichtung.

Fig. 3b eine Darstellung gemäss Fig. 3a für die normale Betriebsfunktion beim Erkennen eines Hindernisses.

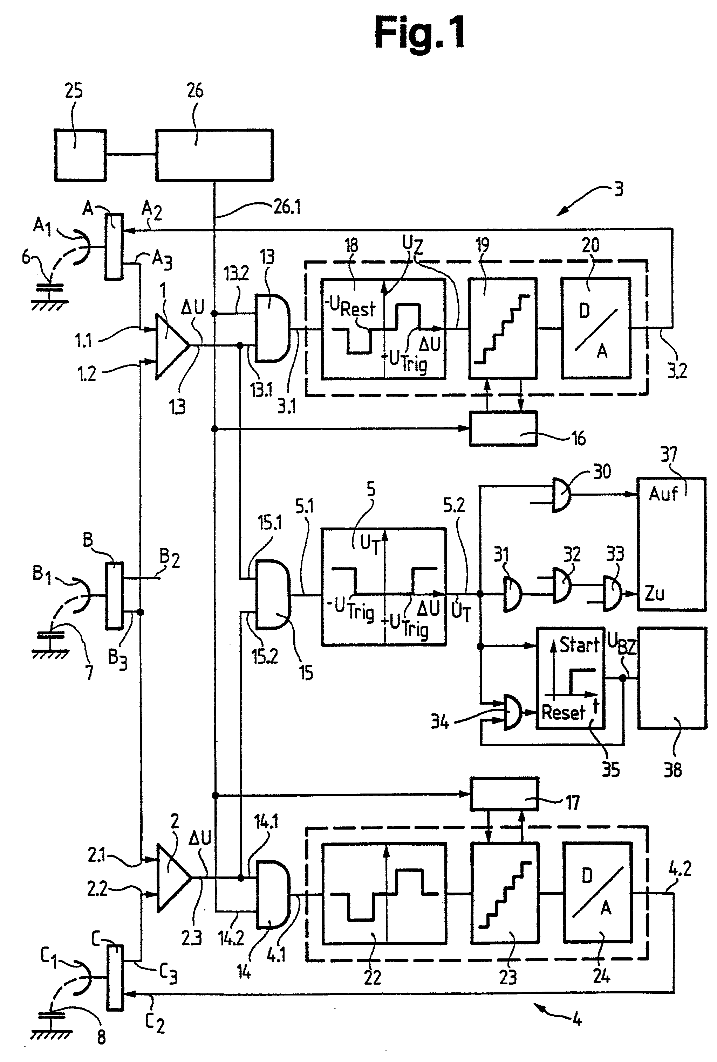

Fig. 1 zeigt eine mögliche Ausführungsform der erfindungsgemässen Einrichtung, bestehend aus drei entlang einer Türschliesskante angeordneten kapazitiven Sensoren A,B,C; zwei Differentialverstärkern 1, 2 zum Empfang und Vergleich je zweier Sensorsignale und zur Erzeugung je eines Fehlersignales; zwei Kompensatoren 3, 4 zur Kompensation der Fehlersignale sowie einer Auswerteschaltung 5 zur Erzeugung eines Türsteuerungssignales $U_T$. Die Sensoren A,B,C sind je mit einer auf der Türkante angebrachten Antenne $A_1$, $B_1$, $C_1$ verbunden, von denen jede eine, zum Teil einbaubedingte, Kapazität 6, 7, 8 gegen Erde aufweist. Im weitern besitzt jeder Sensor A,B,C einen Kompensationseingang $A_2$, $B_2$, $C_2$, von denen $A_2$ und $C_2$ mit den Kompensatorausgängen 3.2, 4.2 verbunden sind, während $B_2$ nicht angeschlossen ist. Je zwei Sensorausgänge $A_3$, $B_3$ und $B_3$, $C_3$ sind paarweise an die Eingänge 1.1, 1.2 bzw. 2.1, 2.2 der entsprechenden Differentialverstärker 1, 2 geführt. Die Ausgänge 1.3, 2.3 der Differentialverstärker 1, 2 stehen mit den Eingängen 13.1, 14.1 der Analoggates 13 bzw. 14 in Verbindung und parallel dazu auch mit den Eingängen 15.1 und 15.2 des Majoritätsgates 15, wodurch an den Ausgängen 1.3, 2.3 auftretende Fehlersignale $\Delta U$ in die Kompensatoren 3, 4 und in die Auswerteschaltung 5 eingekoppelt sind. Die Kompensatoren 3, 4 sind identisch aufgebaut und wirken je mit einem inkrementalen Abgleichspeicher 16 bzw. 17 zusammen. Der Kompensator 3 besteht aus dem Schwellwertdetektor 18, dem Vorwärts-/Rückwärtszähler 19 sowie dem Digital-/Analogwandler 20 und ist an seinem Eingang 3.1 mit dem Analoggate 13 und an seinem Ausgang 3.2 mit dem Kompensationseingang $A_2$ des Sensors A verbunden. In gleicher Weise enthält der Kompensator 4 den Schwellwertdetektor 22, den Vorwärts-/Rückwärtszähler 23 und den Digital-/Analogwandler 24 sowie die Verbindung seines Einganges 4.1 mit dem Analoggate 14 und seines Ausganges 4.2 mit dem Kompensationseingang $C_2$ des Sensors C. Grundlage und Ausgangspunkt des Kompensationsvorganges ist der Türwegdetektor 25, der zur feinstufigen bzw. quasistetigen Messung des Türweges, bei wegabhängigen Türantriebsregulierungen ohnehin zur Verfügung steht. Der Türwegdetektor 25 treibt einen Pulsgenerator 26, der pro Wegstrecke $\Delta S$ (z.B. 1 cm) an seinem Ausgang 26. 1 einen Wegstreckenimpuls $I_s$ mit einstellbarer Impulsbreite $\tau$ erzeugt. Diese Rechteckimpulse $I_s$ steuern die Funktion der Kompensatoren 3, 4 und sind hiezu auf die Eingänge 13.2, 14. 2 der Analoggates 13, 14 und auf die inkrementalen Abgleichspeicher 16, 17 geführt. Die Auswerteschaltung 5 ist als einfacher Schwellwertdetektor mit den Schwellwerten $\pm U_{Trig}$ ausgebildet. Sie ist über das Majoritätsgate 15 zu den Kompensatoren 3, 4 parallel geschaltet, so dass an ihrem Eingang 5.1 das jeweils absolut grösste Fehlersignal $\Delta U$ ansteht. Am Ausgang 5.2 ist das Türsteuerungssignal $U_T$ über die Torschaltungen 30, 31, 32, 33, 34 und 35 auf den Türantrieb 37 und den Buzzer 38 geführt.

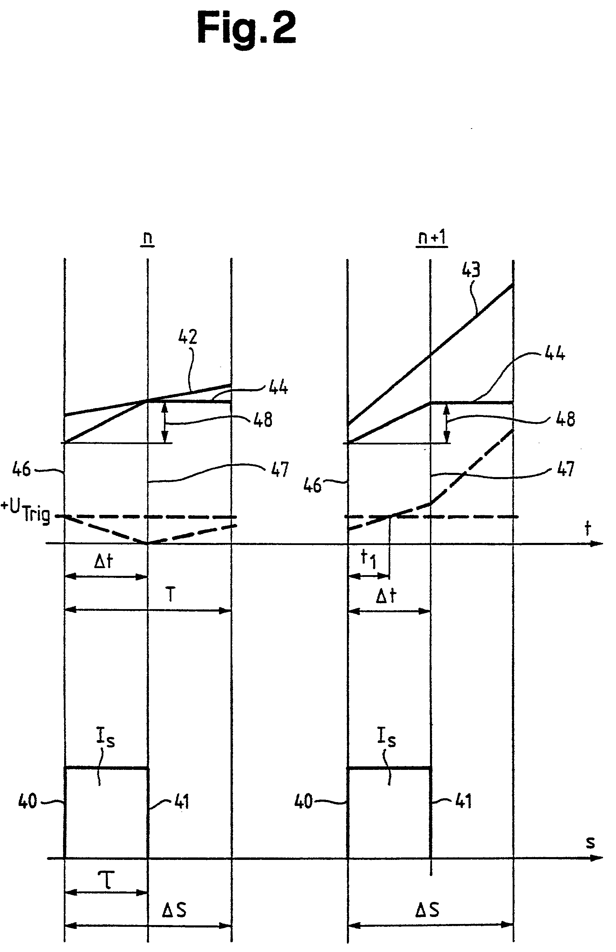

Die Wegstreckenimpulse $I_s$, die zur Steuerung des Kompensationsvorganges pro Wegstrecke $\Delta S$ vom Pulsgenerator 26 ab gegeben werden, sind aus Fig. 2 ersichtlich. Jeder Impuls $I_s$ enthält eine ansteigende Flanke 40, eine abfallende Flanke 41 sowie eine einstellbare Impulsbreite $\tau$. Weiter zeigt die Fig. 2 den grundlegenden Kompensationsvorgang für ein langsamveränderliches unkompensiertes Fehlersignal 42 im Bereiche der n-ten Wegstrecke $\Delta S$ und für ein schnellveränderliches unkompensiertes Fehlersignal 43 im Bereiche der (n+1)-ten Wegstrecke $\Delta S$. In beiden Fällen ist das Kompensationssignal 44 durch einen Anfangswert 46, einen Endwert 47, sowie eine während der Kompensationszeit $\Delta t$ maximal erreichbare Kompensationswertänderung 48 charakterisiert. Durch das Kompensationssignal 44 ist das langsamveränderliche Fehlersignal 42 auf einen Wert kleiner $+U_{Trig}$ der Auswerteschaltung 5 reduziert, während das schnellveränderliche Fehlersignal 43 den Schwellwert $+U_{Trig}$ bereits nach $t_1$ übersteigt.

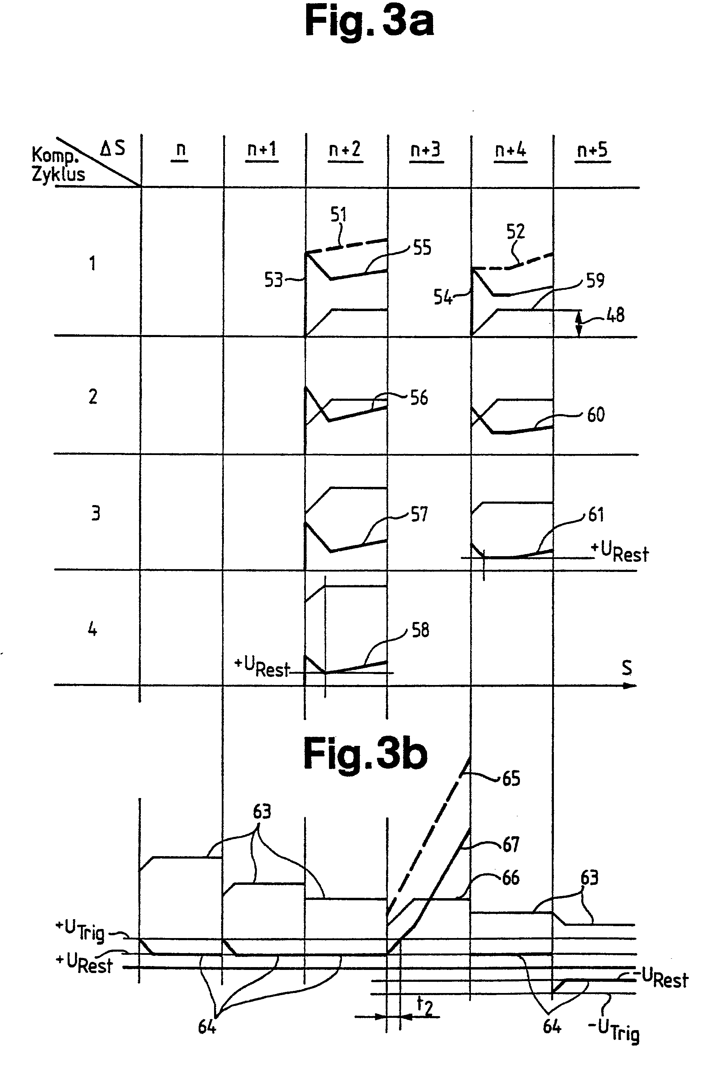

Anhand der Figuren 3a und 3b sind die Verhältnisse beim Initialisieren der Einrichtung bzw. beim Erkennen eines Hindernisses dargestellt.

In Fig. 3a geht es darum, bei Inbetriebnahme der Einrichtung, die in den (n+2)-ten und (n+4)-ten Wegstrecken $\Delta S$ durch z.B. bauliche Störbeeinflussungen verursachten langsamveränderlichen unkompensierten Fehlersignale 51, 52 mit den Anfangsamplituden 53, 54 zu kompensieren. Es handelt sich also um einen Abgleich der entsprechenden Sensoren bezüglich der anfänglichen Störbeeinflussungen. Aufgrund der Amplituden der zugrunde gelegten Fehlersignale 51, 52 sind hiezu für die (n+2)-te und (n+4)-te Wegstrecke $\Delta S$ vier bzw. drei Kompensationszyklen erforderlich, mit den Kompensationsschritten 55, 56, 57, 58 bzw. 59, 60, 61. Fig. 3b zeigt als Oszillogramm Kompensationssignale 63 und kompensierte Fehlersignale 64 für eine vollständig initialisierte Anlage, bei der sich im Bereiche der (n+3)-ten Wegstrecke ein Hindernis, z.B. eine die Aufzugskabine betretende Person, befindet. Das entsprechende unkompensierte Fehlersignal 65 kann mit dem Kompensationssignal 66 nicht vollständig kompensiert werden, so dass das nur teilweise kompensierte Fehlersignal 67 den Schwellwert $+U_{Trig}$ der Auswerteschaltung 5 nach $t_2$ übersteigt.

Die Signale, welche in den Fig. 2, 3a und 3b zur Vereinfachung linear bzw. stückweise -linear angenommen sind, können im allgemeinen Falle selbstverständlich auch einen nichtlinearen Verlauf aufweisen.

Die Funktionsweise der erfindungsgemässen Neuerung sei im folgenden anhand ihrer wesentlichen Funktionen, nämlich Kompensation, Initialisierung und Hinderniserkennung erläutert und dabei auf die Figuren 1 bis 3 hingewiesen. Zur Erklärung des Kompensationsvorganges sei angenommen, eine mit der Erfindung ausgerüstete automatische Türe befinde sich in der Schliessbewegung und treffe mit ihrer Schliesskante auf eine Störbeeinflussung z.B. durch Schmutz, Temperatur oder mechanische Toleranzen oder auf ein Hindernis, wie Personen oder Gegenstände, wodurch in beiden Fällen die Erdkapazitäten mindestens zweier benachbarter Sensorantennen verändert werden. Weiter sei angenommen, dass diese Kapazitätsänderung die beiden Sensoren A und B betreffe und deshalb ungleiche Sensorsignale an den Eingängen 1.1, 1.2 des Differentialverstärkers 1 erzeuge, so dass von dessen Ausgang 1.3 ein Fehlersignal $\Delta U$ an die Eingänge 13.1 und 15.1 des Analoggates 13 bzw. des Majoritätsgates 15 geführt wird. Die nun folgende Kompensation des Fehlersignales $\Delta U$ ist für jede Wegstrecke $\Delta S$ durch den zugehörigen Wegstreckenimpuls $I_s$ gesteuert. Mit seiner ansteigenden Flanke 40 wird vorerst der beim vorhergehenden Kompensationszyklus für die gleiche Wegstrecke $\Delta S$ und das gleiche Stockwerk ermittelte Kompensationswert 46 in den Vorwärts-/Rückwärtszähler 19 eingelesen (presetting). Anschliessend wird das Fehlersignal $\Delta U$ während der Impulsdauer $\tau$ über das Analoggate 13 auf den Schwellwertdetektor 18 gegeben, der $\Delta U$ auf sein Vorzeichen prüft und je nach Amplitude an den Vorwärts-/Rückwärtszähler weiterleitet. Ein erster Schwellwert $\pm U_{Rest}$ bestimmt jene Grenzwerte, innerhalb derer das Fehlersignal $\Delta U$ nach erfolgter Kompensation liegen soll. Fehlersignale im Bereiche $\pm U_{Rest}$ werden also nicht kompensiert. Ein zweiter Schwellwert $\pm U_{Trig}$ definiert jenen maximalen Wert von $\Delta U$, der durch unter schiedliche Türkapazitäten pro Stockwerk oder durch Langzeiteinflüsse (Deformationen, Temperatur, Feuchtigkeit) bei hindernisfreiem Türeingang entstehen kann. Im Bereich $U_{Rest} \leq |\Delta U| \leq U_{Trig}$, also im Kompensationsbereich, steht am Ausgang des Schwellwertdetektors 18 ein Signal $U_Z$ an, das den Zähler 19 je nach Vorzeichen von $\Delta U$ vor- bzw. rückwärts laufen lässt und damit über den D/A Wandler 20 am Kompensationseingang $A_2$ eine Kompensationsspannung erzeugt, die $\Delta U$ abnehmen lässt bis $|\Delta U| <$ $U_{Rest}$ ist; $U_Z$ verschwindet, der Zähler bleibt stehen. Zum Abschluss des Kompensationsvorganges wird mit der abfallenden Flanke 41 von $I_S$ der zuletzt anstehende Zählerwert, d.h. der Kompensationswert 47 für die zugehörige Wegstrecke $\Delta S$ und das vorliegende Stockwerk im Abgleichspeicher 16 gespeichert, um zu Beginn der nächsten Kompensation der gleichen Wegstrecke $\Delta S$ mit der ansteigenden Flanke 40 von $I_S$ als neuer Kompensationswert 46 in den Vorwärts-/Rückwärtszähler eingelesen zu werden. Da der Türwegdetektor 25 den Türweg S feinstufig bzw. quasistetig in Wegstrecken $\Delta S$ aufteilt, können Fehlersignale $\Delta U$ mit hohem räumlichen Auflösungsvermögen auf minimale Restamplituden auskompensiert werden. Die während einer Wegstrecke $\Delta S$ maximal erreichbare Kompensationswertänderung 48 bestimmt die Grenze zwischen langsamveränderlichen Fehlersignalen, die vollständig kompensiert werden und schnellveränderlichen Fehlersignalen, die nur zu einem geringen Teil kompensiert werden. Da dieser Grenzwert anlagenspezifisch, z.B. von der als Zeitkompression oder Zeitexpansion wirkenden Türgeschwindigkeit abhängt, ist für jede Türanlage eine entsprechende Anpassung der maximalen Kompensationswertänderung 48 notwendig. Im vorliegenden Falle ist dies durch eine veränderbare Kompensationszeit $\Delta t$ gewährleistet, wozu die Impulsbreite $\tau$ im Pulsgenerator 26 einstellbar ist. In analoger Weise werden die Fehlersignale $\Delta U$ der Sensoren B und C am Ausgang 2.3 des Differentialverstärkers 2 durch den Kompensator 4 und den Abgleichspeicher 17 kompensiert. Die zu den Kompensatoren 3, 4 parallel geschaltete Auswerteschaltung 5 ist ein reiner Amplitudendiskriminator. Nur Fehlersignale, deren Amplituden trotz Kompensation im Bereiche - $U_{Trig} >$ $\Delta U > + U_{Trig}$ liegen, werden vom Schwellwertdetektor auf die Türsteuerung durchgeschaltet und können so türsteuernd wirksam sein. Es ist offensichtlich, dass die Kompensation gleichermassen auf durch Störbeeinflussungen wie durch Hindernisse verursachte Fehlersignale $\Delta U$ wirkt. Zur Differentiierung zwischen den beiden geht man von der Erkenntnis aus, dass bei normalem Aufzugsbetrieb Störbeeinflussungen und Hindernisse langsamveränderliche bzw. schnellveränderliche Fehlersignale $\Delta U$ erzeugen. Mittels der Impulsbreite $\tau$, welche zur Verbesserung der Anlagenspezifität einstellbar ist, wird dann die Kompensationszeit $\Delta t$ so gewählt, dass mit der während einer Wegstrecke $\Delta S$ maximal erreichbaren Kompensationswertänderung 48 langsamveränderliche Fehlersignale vollständig kompensiert werden, während schnellveränderliche Fehler signale nach Kompensation noch genügend Amplitude aufweisen, um über die Auswerteschaltung 5 türsteuernd wirksam zu sein.

Das Initialisieren gemäss Fig. 3a bedeutet Kompensation der nach Installation anfänglich vorhandenen Störbeeinflussungen wie z.B. durch bauliche Konstruktionselemente im Aufzugschacht, mechanische Toleranzen, Unsymmetrien in der elektronischen Schaltung usw. und gewährleistet damit eine selbsttätige gegenseitige Abstimmung von Türanlage und erfindungsgemässer Einrichtung. Dies ist notwendig, weil sonst die Störbeeinflussungen die Ansprechempfindlichkeit der Hinderniserkennung unzulässig reduzieren würden. Die Türe wird deshalb anfänglich den ganzen Türbereich in hindernisfreiem Zustand so lange betriebsmässig durchfahren, bis alle Störbeeinflussungen, die ja langsamveränderlich sind, durch sukzessive Kompensation unwirksam gemacht sind. Die erfindungsgemässe Einrichtung beobachtet also den Türbereich in hindernisfreiem Zustand und merkt sich Ort und Amplitude jeder Störbeeinflussung. Die in der (n+2)-ten Wegstrecke $\Delta S$ angenommene Störbeeinflussung 51 wird durch das vorgenannte Kompensationsverfahren in vier Schritten 55, 56, 57, 58 auf eine Amplitude kleiner $U_{Rest}$ reduziert. Da die Störbeeinflussung 52 in der (n+4)-ten Wegstrecke $\Delta S$ eine kleinere Amplitude als die Störbeeinflussung 51 aufweist, ist bei gleicher maximaler Kompensationswertänderung 48 der Schwellwert $+U_{Rest}$ bereits nach den drei Schritten 59, 60, 61 erreicht. Nach erfolgter Initialisierung enthalten die inkrementalen Abgleichspeicher 16, 17 je ein wegstrecken- und stockwerkbezogenes, amplitudenmässiges Abbild der über den Türbereich verteilten Störbeeinflussungen. Dieses Abbild wird bei jeder Türbewegung korrigiert, d.h. auf den neuesten Stand gebracht.

Fig. 3b ist eine Illustration von Funktionsablauf und Kurvenformen beim betriebsmässigen Erkennen eines Hindernisses (Person oder Gegenstand), dessen kapazitive Auswirkungen der Einfachheit halber auf die (n+3)-te Wegstrecke beschränkt ist. Da in allen Wegstrecken $\Delta S$ die zugehörigen Störbeeinflussungen durch die Kompensationssignale 63 zu Fehlersignalen 64 kompensiert sind, kann das Hindernis in der (n+3)-ten Wegstrecke mit voller Empfindlichkeit detektiert werden. Das entsprechende Fehlersignal 65 ist schnellveränderlich, so dass seine Kompensation durch das Kompensationssignal 66 auf ein Fehlersignal 67 führt, das den Schwellwert $+U_{Trig}$ der Auswerteschaltung 5 schon nach $t_2$ erreicht und damit türsteuernd wirksam wird. Dies kann zu einem Stop oder einer Reversierung des Türantriebes führen, beides Funktionen, die gegenüber dem Schliessbefehl dominant sind. Normalerweise verschwindet das Hindernis nach kurzer Zeit, so dass das Fehlersignal $\Delta U < U_{Trig}$ ist; die Tür schliesst wieder. Bleibt das Hindernis, so wird nach der wählbaren Zeit $T_B$ ein Signal $U_{BZ}$ an den Buzzer gegeben und gleichzeitig der Türschliessvorgang mit reduzierter Geschwindigkeit eingeleitet. Selbstverständlich wird ein Hindernis auch bei Überlagerung durch eine Störbeeinflussung detektiert, wobei diese Störbeeinflussung nach einigen Kompensationszyklen türsteuerungsmässig vollständig unwirksam gemacht ist.

Es ist dem Fachmann einleuchtend, dass die Erfindung nicht auf das vorgenannte Ausführungsbeispiel beschränkt ist. So ist möglich, andere Sensoren zu verwenden, welche z.B. licht-elektrisch oder induktiv oder mit Ultraschallmessung arbeiten und auch die Anzahl der über der Türkante verteilten Sensoren braucht keineswegs auf drei beschränkt zu sein. Im weitern können Kompensatoren und Schaltlogik in herkömmlicher Komponententechnik oder, bei prozessorgesteuerten Türantrieben, in digitaler Computertechnik ausgeführt sein, wobei die Funktionen für Amplitudendiskrimination, Vorwärts-/Rückwärtszählung, Vergleichung, Zeitbestimmung usw. vorteilhaft als Unterprogramme konzipiert sind. Sämtliche Erfindungsmerkmale der antragsgemässen Einrichtung bleiben dabei voll gewahrt.

**Patentansprüche**

1. Einrichtung an automatischen Türen zur Erkennung von Hindernissen, enthaltend kapazitive Sensoren (A, B, C,...), die je ein Sensorsignal ($U_A$, $U_B$, $U_C$,...) abgeben und über die Türschliesskante verteilte Antennen ($A_1$, $B_1$, $C_1$,...) aufweisen; Differentialverstärker (1, 2, ...) zum Empfang und Vergleich je zweier Sensorsignale ($U_A$, $U_B$, $U_C$,...) und zur Erzeugung je eines Fehlersignales ($\Delta U$); auf die kapazitiven Sensoren (A, B, C,...) einwirkende Kompensatoren (3, 4) zur Kompensation je eines Fehlersignales ($\Delta U$); sowie eine Auswerteschaltung (5) zur Abgabe eines Türsteuerungssignales ($U_T$),
**dadurch gekennzeichnet,**
dass mit mindestens einem, von einem den vollen Bewegungsbereich einer Tür in Wegstrecken ($\Delta S$) feinstufig abtastenden Türwegdetektor (25) gesteuerten amplitudenselektiven Kompensator (3, 4) die Fehlersignale ($\Delta U$) bei jeder Türbewegung stückweise, für jede Wegstrecke ($\Delta S$) eines Türweges (S), so kompensiert werden, dass nur während der Schliessbewegung schnellveränderliche Fehlersignale ($\Delta U$) über die Auswerteschaltung (5) türsteuernd wirksam sind.

2. Einrichtung an automatischen Türen nach Anspruch 1,
'**dadurch gekennzeichnet,**
dass zur Steuerung mindestens eines Kompensators (3, 4) ein vom Türwegdetektor (25) getriebener Pulsgenerator (26) vorgesehen ist, der pro Wegstrecke ($\Delta S$) eines Türweges (S) einen Wegstreckenimpuls ($I_S$) mit Impulsbreite ($\tau$) an den Kompensator (3, 4) abgibt.

3. Einrichtung an automatischen Türen nach Anspruch 1,
**dadurch gekennzeichnet,**
dass der Kompensator (3, 4) einen Schwellwertdetektor (18, 22), einen Vorwärts-/Rückwärtszähler (19, 23) sowie einen Digital-/Analogwandler (20, 24) enthält und mit einem inkrementalen Abgleichspeicher (16, 17) zusammenwirkt.

4. Einrichtung an automatischen Türen nach Anspruch 3,
**dadurch gekennzeichnet,**

dass für jede Wegstrecke ($\Delta S$) die Kompensationszeit ($\Delta t$) zur Kompensation eines Fehlersignales ($\Delta U$) kleiner ist als die entsprechende Türlaufzeit (T).

5. Einrichtung an automatischen Türen nach Anspruch 3,
**dadurch gekennzeichnet,**
dass für jede Wegstrecke ($\Delta S$) der nach Ablauf der Kompensationszeit ($\Delta t$) vorliegende Kompensationswert (47) während der verbleibenden Türlaufzeit (T-$\Delta t$) konstant gehalten ist und pro Wegstrecke ($\Delta S$) und pro Stockwerk als Ausgangsgrösse für die nächste Kompensation der gleichen Wegstrecke ($\Delta S$) im Abgleichspeicher (16, 17) gespeichert wird.

6. Einrichtung an automatischen Türen nach Anspruch 3,
**dadurch gekennzeichnet,**
dass für jede Wegstrecke ($\Delta S$) mit der während der Kompensationszeit ($\Delta t$) maximal erreichbaren Kompensationswertänderung (48) schnellveränderliche Fehlersignale ($\Delta U$) nur zu einem geringen Teil kompensierbar sind und deshalb über die als Schwellwertdetektor ausgebildete Auswerteschaltung (5) türsteuernd wirksam sind.

7. Einrichtung an automatischen Türen nach Anspruch 3,
**dadurch gekennzeichnet,**
dass die Kompensationszeit ($\Delta t$) jeder Wegstrecke ($\Delta S$) mit der Impulsdauer ($\tau$) des entsprechenden Wegstreckenimpulses ($I_S$) zusammenfällt.

8. Einrichtung an automatischen Türen nach Anspruch 7,
**dadurch gekennzeichnet,**
dass die während der Türlaufzeit (T) für eine Wegstrecke ($\Delta S$) maximal erreichbare Kompensationswertänderung (48) mittels der Kompensationszeit ($\Delta t$) veränderbar ist, und dass hiefür die Impulsbreite ($\tau$) im Pulsgenerator (26) einstellbar ist.

9. Einrichtung an automatischen Türen nach Anspruch 3,
**dadurch gekennzeichnet,**
dass der für eine Wegstrecke ($\Delta S$) ermittelte Kompensationswert (47) bei der abfallenden Flanke (41) des zugehörigen Wegstreckenimpulses ($I_S$) vom Kompensator (3, 4) in den Abgleichspeicher (16, 17) und bei der ansteigenden Flanke (40) des nächsten Wegstreckenimpulses ($I_S$) der gleichen Wegstrecke ($\Delta S$) in umgekehrter Richtung transferiert wird.

10. Einrichtung an automatischen Türen nach Anspruch 3,
**dadurch gekennzeichnet,**
dass die Amplitudenselektivität des Kompensators (3, 4) durch den Schwellwertdetektor (18, 22) gewährleistet ist, wobei Fehlersignale ($\Delta U$) nur im Bereiche $U_{Rest} \leq |\Delta U| \leq U_{Trig}$ kompensierbar sind.

11. Einrichtung an automatischen Türen nach Anspruch 1,
**dadurch gekennzeichnet,**
dass ein Majoritätsgatter (15) vorgesehen ist, das für jede Wegstrecke ($\Delta S$) nur das absolut grösste Fehlersignal ($\Delta U$) auf die Auswerteschaltung (5) durchschaltet.

12. Einrichtung an automatischen Türen nach Anspruch 1,
**dadurch gekennzeichnet,**
dass die Auswerteschaltung (5) ein Schwellwertschalter ist, wobei nur Fehlersignale ($\Delta U$) im Bereiche - $U_{Trig} \geq \Delta U \geq + U_{Trig}$ türsteuernd wirksam sind.

13. Einrichtung an automatischen Türen nach den Ansprüchen 10 und 12,
**dadurch gekennzeichnet,**
dass die Kompensatoren (3, 4) und die Auswerteschaltung (5) die gleichen Schwellwerte ± $U_{Trig}$ aufweisen.

## Claims

1. Equipment on automatic doors for the recognition of obstacles, comprising capacitive sensors (A, B, C, ...), which each emit a sensor signal ($U_A$, $U_B$, $U_C$, ...) and exhibit antennas ($A_1$, $B_1$, $C_1$, ...) distributed across the closing edge of the door; differential amplifiers (1, 2, ...) for the reception and comparison of two each sensor signals ($U_A$, $U_B$, $U_C$, ...) and for the generation of one each error signal ($\Delta U$); compensators (3, 4) acting on the capacitive sensors (A, B, C, ...) for the compensation of one each error signal ($\Delta U$); as well as an evaluating circuit (5) for the emission of a door control signal ($U_T$), so characterized, that with at least one amplitude selective compensator (3, 4) controlled by a door travel detector (25) sampling the entire range of movement of a door by travel distances ($\Delta S$) in fine steps, the error signals ($\Delta U$) at every motion of the door are compensated in small increments for every travel distance ($\Delta S$) of a door travel (S) in such a manner, that only during the closing movement are rapidly variable error signals ($\Delta U$) active in controlling the door through the evaluating circuitry (5).

2. Equipment on automatic doors according to claim 1, so characterized, that for control of at least one compensator (3, 4) a pulse generator (26) driven by the door travel detector (25) is provided, which transmits per travel distance ($\Delta S$) of a door travel (S) a travel distance pulse ($I_S$) with (a) pulse width ($\tau$), to the compensator (3, 4).

3. Equipment on automatic doors according to claim 1, so characterized, that the compensator (3, 4) comprises a threshold value detector (18, 22), a forward-/reverse counter (19, 23) as well as a digital-/analog converter (20, 24) and (which) acts together with an incremental balancing storage (16, 17).

4. Equipment on automatic doors according to claim 3, so characterized, that for every travel distance ($\Delta S$) the compensation time ($\Delta t$) for compensation of an error signal ($\Delta U$) is smaller than the corresponding door running (operating) time (T).

5. Equipment on automatic doors according to claim 3, so characterized, that the compensation value (47), existing after expiration of the compensation time ($\Delta t$) for every travel distance ($\Delta S$), is maintained constant during the remaining door travel (or running) time (T- $\Delta t$) and is stored as starting value per floor for the next compensation of the identical travel distance ($\Delta S$) in the balancing storage (16, 17).

6. Equipment on automatic doors according to claim 3, so characterized, that for every travel distance ($\Delta S$) with, during the compensating time ($\Delta t$), maximally attainable compensating value variation (48), rapidly variable error signals ($\Delta U$) can only be compensated to a small degree and are therefore active in door control by way of the evaluating circuit (5) designed as threshold value detector.

7. Equipment on automatic doors according to claim 3, so characterized, that the compensation time ($\Delta t$) of every travel distance ($\Delta S$) coincides with the pulse duration ($\tau$) of the corresponding travel distance pulse ($I_S$).

8. Equipment on automatic doors according to claim 7, so characterized, that the compensating value variation (48), maximally attainable during the door travel (or running) time (T) for a travel distance ($\Delta S$), is variable by means of the compensating time ($\Delta t$), and for this the pulse width ($\tau$) in the pulse generator (26) is adjustable.

9. Equipment on automatic doors according to claim 3, so characterized, that the compensating value (47), determined for a travel distance ($\Delta S$), is transferred by the compensator (3, 4) at the dropping side (41) of the pertaining travel distance pulse ($I_S$) into the balancing storage (16, 17) and at the rising side (40) of the next travel distance pulse ($I_S$) of the same travel distance ($\Delta S$) in a reverse direction.

10. Equipment on automatic doors according to claim 3, so characterized, that the amplitude selectivity of the compensator (3, 4) is assured by the threshold value detector (18, 22), where the error signals ($\Delta U$) can only be compensated in the range $U_{Rest} \leq |\Delta U| \leq U_{Trig}$.

11. Equipment on automatic doors according to claim 1, so characterized, that a majority gate circuit (15) is provided, which for every travel distance ($\Delta S$) switches only the absolutely largest error signal ($\Delta U$) into the evaluating circuit (5).

12. Equipment on automatic doors according to claim 1, so characterized, that the evaluating circuit (5) consists of a threshold value switch where only error signals ($\Delta U$) in the range $-U_{Trig} \geq \Delta U \geq + U_{Trig}$ are acting in the door control (or: are door controllingly active).

13. Equipment on automatic doors according to the claims 10 and 12, so characterized that the compensators (3, 4) and the evaluating circuit (5) exhibit the same threshold values ±$U_{Trig}$.

## Revendications

1. Dispositif installé sur des portes automatiques pour identifier des obstacles, et comprenant: des capteurs capacitifs (A, B, C, ...), qui délivrent chacun un signal ($U_A$, $U_B$, $U_C$, ...) et possèdent des antennes ($A_1$, $B_1$, $C_1$, ...) réparties sur le bord de fermeture de la porte; des amplificateurs différentiels (1, 2, ...) servant à recevoir et comparer respectivement deux signaux ($U_A$, $U_B$, $U_C$, ...) des capteurs et à produire respectivement un signal d'erreur ($\Delta U$); des compensateurs (3, 4) agissant sur les capteurs capacitifs (A, B, C, ...) et servant à compenser chacun un signal d'erreur ($\Delta U$); ainsi qu'un circuit d'évaluation (5) servant à délivrer un signal ($U_T$) de commande de la porte, caractérisé en ce qu'au moins un compensateur (3, 4) sélectif du point de vue de l'amplitude et commandé par un détecteur (25) du trajet de déplacement de la porte, qui explore la course complète de déplacement d'une porte, par pas fins, sur des sections ($\Delta S$) de son trajet, compense les signaux d'erreur ($\Delta U$) pas-à-pas lors de chaque déplacement de la porte, pour chaque section ($\Delta S$) d'un trajet de déplacement (S) de la porte, de telle façon que seulement pendant le mouvement de fermeture, des signaux d'erreurs ($\Delta U$) à variation rapide agissent sur la commande de la porte par l'intermédiaire du dircuit d'évaluation (5).

2. Dispositif installé sur des portes automatiques selon la revendication 1, caractérisé en ce que pour la commande d'au moins un compensateur (3, 4), il est prévu un générateur d'impulsions (26) qui est piloté par le détecteur (25) du trajet de déplacement de la porte et délivre, pour chaque section ($\Delta S$) d'un trajet de déplacement (S) de la porte, une impulsion (IS) de la section du trajet de déplacement de durée ($\tau$), au compensateur (3, 4).

3. Dispositif installé sur des portes automatiques selon la revendication 1, caractérisé en ce que le compensateur (3, 4) contient un détecteur à valeur de seuil (18, 22), un compteur progressif/régressif (19, 23) ainsi qu'un convertisseur numérique/analogique (20, 24), et coopère avec une mémoire incrémentale d'équilibrage (16, 17).

4. Dispositif installé sur des portes automatiques selon la revendication 3, caractérisé en ce que, pour chaque section ($\Delta S$), le temps de compensation ($\Delta t$) pour compenser un signal d'erreur ($\Delta U$) est inférieur au temps correspondant (T) de déplacement de la porte.

5. Dispositif installé sur des portes automatiques selon la revendication 3, caractérisé en ce que pour chaque section ($\Delta S$) du trajet de déplacement, la valeur de compensation (47) présente après l'écoulement du temps de compensation ($\Delta t$) est maintenue constante pendant le reste (T-$\Delta t$) du temps de déplacement de la porte et est mémorisée, pour chaque section de trajet ($\Delta S$) et pour chaque étage, en tant que grandeur de sortie pour la compensation suivante de la même section ($\Delta S$) du trajet de déplacement, dans la mémoire d'équilibrage (16, 17).

6. Dispositif installé sur des portes automatiques selon la revendication 3, caractérisé en ce que pour chaque section ($\Delta S$) du trajet de déplacement, les signaux d'erreur ($\Delta U$) à variation rapide peuvent être compensés, seulement pour une faible partie, à l'aide de la variation (48) de la valeur de compensation, qui peut atteindre une valeur maximum pendant le temps de compensation ($\Delta t$), et exercent ainsi une action sur la commande de la porte par l'intermédiaire du circuit d'évaluation (5) réalisé sous la forme d'un détecteur à valeurs de seuil.

7. Dispositif installé sur des portes automatiques selon la revendication 3, caractérisé en ce que le temps de compensation ($\Delta t$) et chaque section ($\Delta S$) du trajet de déplacement coïncide avec la durée ($\tau$) de l'impulsion correspondante (IS) de la section du trajet de déplacement.

8. Dispositif installé sur des portes automatiques selon la revendication 7, caractérisé en ce que la variation (48) de la valeur de compensation, qui peut atteindre une valeur maximum pendant le temps (T) de déplacement de la porte pour une section ($\Delta S$) du trajet de déplacement, peut être modifié à l'aide du temps de compensation ($\Delta t$), et en ce qu'à cet effet la durée ($\tau$) des impulsions dans le générateur d'impulsions (26) est réglable.

9. Dispositif installé sur des portes automatiques selon la revendication 3, caractérisé en ce que la valeur de compensation (47) déterminée par une section ($\Delta S$) du trajet de déplacement, est transférée du compensateur (3, 4) dans la mémoire d'équilibrage (16, 17), par le flanc retombant (41) de l'impulsion associée (IS) de la section du trajet de déplacement, et dans le sens inverse par le flanc montant (40) de l'impulsion (IS) immédiatement suivante de la même section ($\Delta S$) du trajet de déplacement.

10. Dispositif installé sur des portes automatiques selon la revendication 3, caractérisé en ce que la sélectivité en amplitude du compensateur (3, 4) est garantie par le détecteur à valeur de seuil (18, 22), auquel cas les signaux d'erreur ($\Delta U$) peuvent être compensés uniquement dans la plage U résiduelle $\leq |\Delta U| \leq$ U déclenchement.

11. Dispositif installé sur des portes automatiques selon la revendication 1, caractérisé en ce qu'il est prévu une porte à logique majoritaire (15), qui, pour chaque section ($\Delta S$) du trajet de déplacement, transmet uniquement le signal d'erreur ($\Delta U$) maximum en valeur absolue, au circuit d'évaluation (5).

12. Dispositif installé sur des portes automatiques selon la revendication 1, caractérisé en ce que le circuit d'évaluation (5) est un commutateur à valeurs de seuil, seuls les signaux d'erreur ($\Delta U$) situés dans la plage $-$U déclenchement $\leq \Delta U \leq +$U déclenchement ayant une action sur la commande de la porte.

13. Dispositif installé sur des portes automatiques selon les revendications 10 et 12, caractérisé en ce que les compensateurs (3, 4) et le circuit d'évaluation (5) possèdent les mêmes valeurs de seuil +U déclenchement.

# Fig.1

# Fig.2

# Fig.3a

# Fig.3b